# EUROPÄISCHE PATENTSCHRIFT

(11) **EP 2 195 670 B1**
(45) Veröffentlichungstag und Bekanntmachung des Hinweises auf die Patenterteilung: **19.01.2011**
(21) Anmeldenummer: 08837754.4
(22) Anmeldetag: 25.09.2008
(51) Int. Cl.: G01R 31/28

(54) **HANDHABUNGSVORRICHTUNG FÜR ELEKTRONISCHE BAUELEMENTE, INSBESONDERE IC'S, MIT TEMPERIERBAREN UMLAUFEINHEITEN**
HANDLER FOR ELECTRONIC COMPONENTS, IN PARTICULAR IC'S, COMPRISING CIRCULATING UNITS, THE TEMPERATURE OF WHICH CAN BE CONTROLLED
DISPOSITIF DE MANIPULATION POUR COMPOSANTS ÉLECTRONIQUES, NOTAMMENT POUR CIRCUITS INTÉGRÉS, POURVU D'UNITÉS THERMORÉGULABLES À MOUVEMENT CIRCULAIRE

(30) Priorität: 05.10.2007 DE 102007047680
(43) Veröffentlichungstag der Anmeldung: 16.06.2010
(73) Patentinhaber: Multitest elektronische Systeme GmbH, 83026 Rosenheim (DE)
(72) Erfinder: THIEL, Stefan, 83022 Rosenheim (DE); PICHL, Franz, 83236 Übersee (DE); JESERER, Günther, 83104 Tuntenhausen (DE); WIESBÖCK, Andreas, 83071 Stephanskirchen (DE)
(74) Vertreter: Bauer, Friedrich
(86) Internationale Anmeldenummer: PCT/EP2008/008154
(87) Internationale Veröffentlichungsnummer: WO 2009/046883

(56) Entgegenhaltungen:
- DE-A1- 10 003 839
- US-A- 3 761 808
- US-A- 5 184 068
- US-A- 6 148 145
- US-A1- 2007 080 703

## Beschreibung

Die Erfindung betrifft eine Handhabungsvorrichtung für elektronische Bauelemente, insbesondere IC's, mit einer Mehrzahl von auf einer Umlaufbahn bewegbaren Umlaufeinheiten, die jeweils mindestens eine Halteeinheit zum Halten eines Bauelements aufweisen und zwischen einer Beladestation zum Beladen der Halteeinheit mit den Bauelementen, einer Teststation zum Zuführen der Bauelemente zu mit einer Testvorrichtung verbundenen Kontaktiereinrichtung und einer Entladestation zum Entfernen der Bauelemente von den Halteeinheiten bewegbar sind, gemäß dem Oberbegriff des Anspruches 1.

Elektronische Bauelemente, wie beispielsweise IC's, werden üblicherweise auf ihre Funktionsfähigkeit hin überprüft, bevor sie beispielsweise auf Leiterplatten montiert oder anderweitig verwendet werden. Die zu testenden Bauelemente werden hierbei von einem üblicherweise als "Handler" bezeichneten Handhabungsautomaten mit Kontaktiereinrichtungen kontaktiert, die insbesondere als Kontaktsockeln ausgebildet sind und mit einem Testkopf einer Testvorrichtung in elektrischem Kontakt stehen. Nach Beendigung des Testvorgangs werden die Bauelemente mittels des Handlers wieder von den Kontakteinrichtungen entfernt und in Abhängigkeit des Testergebnisses sortiert.

Handler arbeiten üblicherweise derart, dass die über eine Beladestation zugeführten Bauelemente zunächst von Halteeinheiten ("Plunger"), die als Vakuumsauger ausgebildet sind, erfasst werden, worauf die Bauelemente dann mittels der Halteeinheiten in eine andere Position überführt und derart ausgerichtet werden, dass sie auf geradlinigem Weg weiter zum Testkopf vorgeschoben werden, um mit den Kontakten des Testkopfs in Kontakt zu gelangen.

Um die Tests unter bestimmten Temperaturbedingungen durchzuführen, ist es weiterhin bekannt, die Bauelemente vor dem Testvorgang auf bestimmte Temperaturen zu temperieren. Diese Temperaturen können beispielsweise in einem Bereich zwischen -60° und +200° C liegen.

Die Temperierung der Bauelemente erfolgt üblicherweise in einem stationären, entsprechend wärmeisolierten Gehäuse auf konvektive und/oder konduktive Weise. Bei der konvektiven Temperierung werden die Bauelemente in dem Gehäuse mit einer entsprechend temperierten Luft oder einem anderen Gas so lange umströmt, bis sie die gewünschte Temperatur erreicht haben. Bei der konduktiven Temperierung liegen die Bauelemente auf einer Heiz- oder Kühlplatte, von der dann die Wärmeübertragung auf die Bauelemente erfolgt.

Um den Testvorgang der Bauelemente auf möglichst wirtschaftliche Weise durchführen zu können, ist es von entscheidender Bedeutung, dass die Handler mit sehr hohen Geschwindigkeiten arbeiten, d.h. dass möglichst hohe Durchsätze erzielt werden. Es ist daher von großer Bedeutung, dass sowohl die Transportzeiten der Bauelemente innerhalb der Handhabungsvorrichtung als auch die Zeitdauer, die für die Temperierung der Bauelemente erforderlich ist, soweit wie möglich verkürzt wird.

Aus der US 2007/0080703 A1 ist eine Handhabungsvorrichtung gemäß dem Oberbegriff des Anspruches 1 bekannt, die zur optischen Vermessung der Kontakte von Halbleiterbauelementen dient. Bei einer derartigen Vorrichtung wird ein achtarmiges, starres Drehkreuz verwendet. Die zu inspizierenden Bauelemente werden dort an den freien äußeren Enden der sich radial nach außen erstreckenden Drehkreuzarme gehalten unter schrittweisem Drehen des Drehkreuzes auf einer kreisförmigen Umlaufbahn bewegt. Diese Druckschrift gibt jedoch keine Hinweise auf eine Temperierung der Bauelemente.

Der Erfindung liegt die Aufgabe zugrunde, eine Handhabungsvorrichtung für elektronische Bauelemente, insbesondere IC's, zu schaffen, die für eine besonders genaue Temperierung der Bauelemente geeignet und für höchste Durchsätze ausgelegt ist.

Diese Aufgabe wird erfindungsgemäß durch eine Handhabungsvorrichtung mit den Merkmalen des Anspruchs 1 gelöst. Vorteilhafte Ausführungsformen der Erfindung sind in den weiteren Ansprüchen beschrieben.

Erfindungsgemäß weisen die Umlaufeinheiten jeweils mindestens eine Temperierkammer auf, in der sich die an den Halteeinheiten gehalterten Bauelemente befinden, so dass die Bauelemente während des Transports von der Beladestation zur Teststation temperierbar sind.

Mit Hilfe der erfindungsgemäßen Handhabungsvorrichtung sind die Bauelemente auf sehr genaue Weise temperierbar, da die Temperierung unmittelbar vor dem Kontaktieren der Bauelemente mit dem Testkopf erfolgt und keine untemperierten Transportwege zwischen der Beladestation und der Teststation vorhanden sind. Weiterhin kann der Durchsatz der Bauelemente durch die Handhabungsvorrichtung beim Testen der Bauelemente unter bestimmten Temperaturbedingungen bedeutend gesteigert werden. Die zu testenden Bauelemente können unmittelbar, nachdem sie von den Halteeinheiten (insbesondere von Vakuumsaugern) der Handhabungsvorrichtung in der Beladestation übernommen worden sind, während ihres weiteren Transportwegs durch die Handhabungsvorrichtung bis zur Testvorrichtung temperiert werden, so dass dieser gesamte Transportweg für die Temperierung optimal genützt wird. Je nach Temperaturanforderungen kann es dabei ausreichend sein, dass die Temperierung der Bauelemente ausschließlich im Bereich der umlaufenden Temperierkammern erfolgt. Es ist jedoch ohne weiteres möglich und unter Umständen auch sehr zweckmäßig, die Bauelemente in einer vor der Beladestation liegenden zusätzlichen Temperierkammer vorzutemperieren.

Gemäß einer vorteilhafen Ausführungsform sind die Temperierkammern wannenförmig ausgebildet und weisen jeweils ein Gehäuse mit einer Bodenplatte, einer vorderen Wand, einer hinteren Wand und Seitenwänden auf, während das Gehäuse radial nach außen geöffnet und zumindest in einem Bereich zwischen der Beladestation und der Teststation von einer konzentrisch zur Kreisbahn angeordneten, stationären Abdeckung überdeckt ist. Eine derartige Abdeckung verhindert auf einfache Weise ein unkontrolliertes Abströmen von temperiertem Fluid radial nach außen. Die Temperatur an den Bauelementen kann damit sehr gleichmäßig mit geringem Temperaturaufwand eingestellt und beibehalten werden. Es ist ohne weiteres möglich, dass sich die Abdeckung um die gesamte Umlaufbahn der Umlaufeinheiten herum erstreckt und lediglich im Bereich der Beladestation, Teststation und Entladestation entsprechende Öffnungen aufweist, um die Bauelemente durch diese Öffnungen hindurch in die Temperaturkammern einführen bzw. aus diesen entfernen zu können.

Gemäß einer vorteilhafen Ausführungsform sind die Halteeinheiten zum Halten der Bauelemente an der Bodenplatte der Umlaufeinheiten bzw. Temperierkammern befestigt und umfassen relativ zur Bodenplatte verschiebbare Druckstößel, an deren vorderem Ende ein Bauelement mittels Unterdruck gehalten wird. Dies ermöglicht es, dass die Umlaufeinheiten, d.h. die Temperierkammern zusammen mit den Halteeinheiten, auf einfache Weise ausgetauscht werden können, falls eine Anpassung der Ausgestaltung bzw. Anordnung der Halteeinheiten, beispielsweise aufgrund geänderter Kontaktsockel auf Seiten des Testkopfs, gewünscht wird.

Gemäß einer vorteilhaften Ausführungsform ist innerhalb der Temperierkammern jeweils eine Mehrzahl von Halteeinheiten angeordnet, die voneinander durch Wärmedämmmaterial getrennt sind, so dass jede Halteeinheit oder eine Untergruppe von Halteeinheiten in einer seitlich vom Wärmedämmmaterial umgebenen Einzelkammer angeordnet ist. Hierdurch können Wärmeverluste sowie ein Wärmeaustausch zwischen den einzelnen Halteeinheiten auf besonders wirkungsvolle Weise vermieden werden.

Gemäß einer vorteilhaften Ausführungsform sind die die Temperierkammern aufweisenden Umlaufeinheiten unabhängig voneinander auf der Kreisbahn bewegbar. Hierdurch kann eine Umlaufeinheit sofort, nachdem das Beladen mit Bauelementen beendet ist, aus dem Bereich der Beladeöffnung weggefahren und temperiert werden, unabhängig davon, ob die vorhergehende Umlaufeinheit bereits aus der Teststation entfernt worden ist. Dies erhöht die Arbeitsgeschwindigkeit, d.h. den Durchsatz der Handhabungsvorrichtung beträchtlich.

Besonders vorteilhaft ist es, wenn die Umlaufeinheiten aus Umlaufwagen bestehen, die an einer stationären, kreisringförmigen Führungseinrichtung geführt sind.

Gemäß einer vorteilhaften Ausführungsform steht eine der Antriebswellen mit einer fluchtend zu dieser angeordneten Vakuum-/Fluidübertragungseinrichtung in Verbindung, mit der Vakuum und/oder Fluid von einer stationären Vakuum-/Fluidversorgungsquelle zu den Halteeinrichtungen übertragen werden kann. Auf diese Weise ist es möglich, Fluid, beispielsweise gereinigte Umgebungsluft, zu den Umlaufeinheiten zu leiten und dort, d.h. in der Nähe der Bauelemente, mit einer Temperiereinrichtung auf die gewünschte Temperatur zu bringen, um die Bauelemente mit einem derart temperierten Fluid zu temperieren. In diesem Fall wird das Fluid somit in unmittelbarer Nähe der Bauelemente temperiert, so dass der verbleibende Leitungsweg zum Bauelement sehr kurz ist und die Temperatur sehr schnell nachgeregelt werden kann, falls dies erforderlich ist.

Besonders vorteilhaft ist es dabei, wenn die Vakuum-/Fluidübertragungseinrichtung ein mit der Antriebswelle drehfest verbundenes Gehäuse und ein innerhalb des Gehäuses angeordnetes, stationär an der Handhabungsvorrichtung befestigbares Zentralteil aufweist, das über Axialbohrungen und diesen zugeordnete Radialbohrungen eine Vakuum- bzw. Fluidverbindung zu radialen Durchlässen des zusammen mit der Antriebswelle drehbaren Gehäuses schafft.

Die Erfindung wird nachfolgend anhand der Zeichnungen beispielhaft näher erläutert. Es zeigen:
- Figur 1 :: eine schematische Darstellung der erfin- dungsgemäßen Handhabungsvorrichtung und umgebender Vorrichtungen bzw. Module, die beim Testen elektronischer Bauelemente verwendet werden,
- Figur 2 :: eine perspektivische Darstellung der Füh- rungen sowie von Teilen der Umlaufwagen und Antriebsmittel der erfindungsgemäßen Handhabungsvorrichtung, wobei lediglich zwei Umlaufwagen dargestellt und eine Mehrzahl von Komponenten nicht dargestellt sind, um die Übersichtlichkeit zu erhöhen,
- Figur 3 :: eine einzelne Führung mit einem teilweise dargestellten Umlaufwagen aus einer ande- ren Perspektive,
- Figur 4 :: eine perspektivische Darstellung der Füh- rungen sowie von Teilen der Umlaufwagen und Antriebsmittel mit im Vergleich zu Figur 2 zusätzlichen Details,
- Figur 5 :: eine perspektivische, teils schematische Darstellung eines Umlaufwagens mit einem als Temperierkammer ausgebildeten Gehäuse im Bereich der Beladeöffnung,
- Figur 6 :: eine teilweise freigeschnittene Darstel- lung des Umlaufwagens mit Temperierkammer von Figur 5, wobei vier Halteeinheiten ("Plunger") für die Bauelemente dargestellt sind,
- Figur 7 :: eine schematische Seitenansicht eines Um- laufwagens mit Antriebsarm zur Verdeutli- chung des Zusammenwirkens mit einer äuße- ren Abdeckung,
- Figur 8 :: eine schematische Draufsicht auf einen Umlaufwagen mit 16 Halteeinheiten,
- Figur 9 :: eine schematische Darstellung der Handha- bungsvorrichtung,
- Figur 10 :: einen Längsschnitt durch die Antriebswel- len im Bereich von Figur 9,
- Figur 11 :: einen Längsschnitt durch die Antriebswel- len, die elektrische Leistungs-/Datenüber- tragungseinrichtung und die Vakuum-/ Fluidversorgungseinrichtung,
- Figur 12 :: eine perspektivische Darstellung der elek- trischen Leistungs-/Datenübertragungsein- richtung,
- Figur 13 :: einen Längsschnitt durch die Vakuum-/ Fluidübertragungseinrichtung im Bereich der Mittelachse,
- Figur 14 :: eine stirnseitige Ansicht auf die Schleif- ringe und Schleifbürsten der elektrischen Leistungsübertragungseinrichtung,
- Figur 15 :: eine stirnseitige Ansicht auf die Schleif- ringe und Kontaktfedern der Datenübertra- gungseinrichtung, und
- Figur 16 :: eine schematische Seitenansicht der Hand- habungsvorrichtung und einer Testvorrich- tung zur Verdeutlichung der Funktionsweise der Handhabungsvorrichtung.

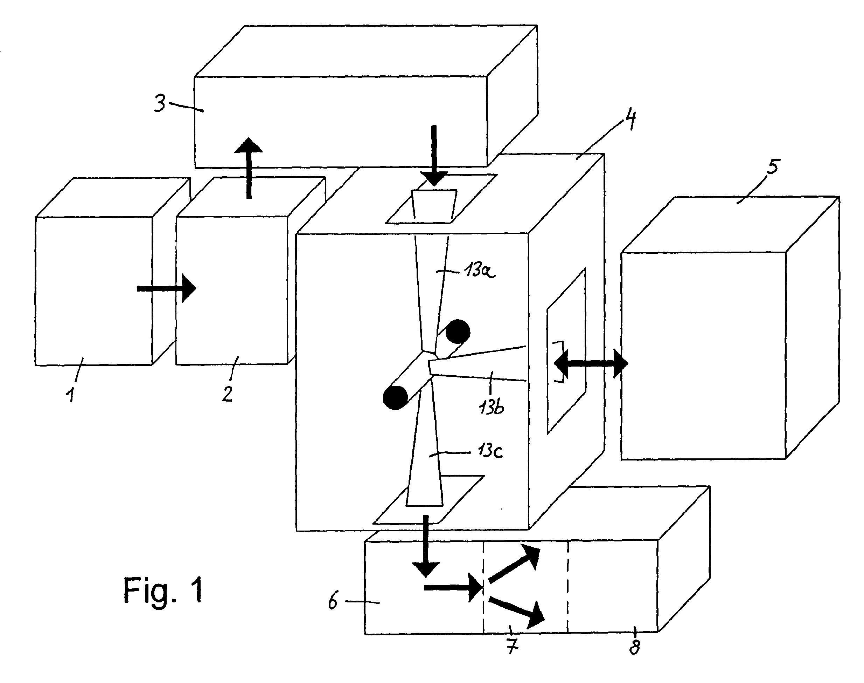

Anhand von Figur 1 wird zunächst schematisch und beispielhaft eine Anlage zum Testen elektronischer Bauelemente in Form von IC's (Halbleiterbauelementen mit integrierten Schaltungen) beschrieben. Die Pfeile geben dabei den Weg der Bauelemente an.

Die Bauelemente werden zunächst einer Ladeeinheit 1 zugeführt. Die Ladeeinheit 1 transportiert die Bauelemente zunächst zu einer vorgeschalteten Temperierkammer 2, um sie innerhalb der Temperierkammer 2 auf eine vorbestimmte Temperatur zu temperieren. Diese kann beispielsweise zwischen -60°C und +200°C liegen. Diese Vortemperierung kann dabei auf konvektive und/oder konduktive Weise erfolgen. Nachdem die zu testenden Bauelemente in der Temperierkammer 2 auf die gewünschte Temperatur gebracht worden sind, werden sie von einer Transporteinheit 3, die beispielsweise eine Pick and Place-Einheit sein kann, aus der Temperierkammer 2 entnommen und einer Handhabungsvorrichtung 4 (Handlerzentraleinheit) zugeführt. Die Handhabungsvorrichtung 4 enthält die notwendigen Einrichtungen zum Aufnehmen, Halten und Temperieren der Bauelemente, und eine Bauelementbewegungseinrichtung, um die Bauelemente einem Testkopf 5 zuzuführen und nach Beendigung des Testvorgangs wieder vom Testkopf 5 zu entfernen. Weiterhin kann die Handhabungsvorrichtung 4 bestimmte Einrichtungen enthalten, um auf die zu testenden Bauelemente in bestimmter Art und Weise einzuwirken, beispielsweise mit Beschleunigungen, Druck oder Neigung der Bauelemente. Der Testkopf 5 wird in bekannter Weise an die Handhabungsvorrichtung 4 angedockt. Der Testkopf 5 ist Teil einer elektronischen Testvorrichtung, mit der die Bauelemente getestet und die Testergebnisse ausgewertet werden.

Nach Beendigung des Tests werden die Bauelemente von der Handhabungsvorrichtung 4 wieder vom Testkopf 5 entfernt und mittels einer Entnahmeeinheit 6 (Unloader oder Pick and Place-Einheit) einer Sortiereinheit 7 zugeführt. In der Sortiereinheit 7 werden die Bauelemente in Abhängigkeit des Testergebnisses sortiert. Anschließend gelangen die Bauelemente zu einer Entladestation 8.

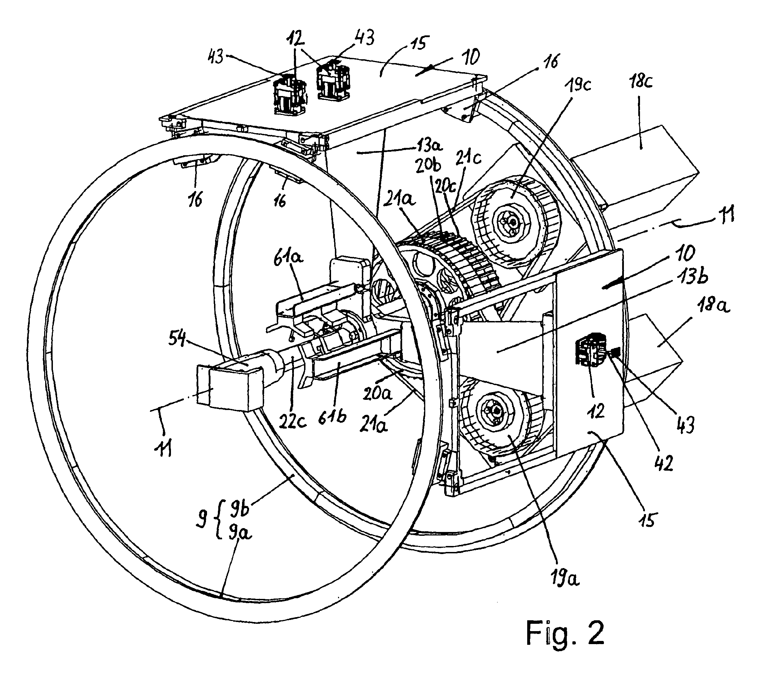

Die außerhalb der Handhabungsvorrichtung 4 angeordnete Temperierkammer 2 ist lediglich optional. Weiterhin muss die Zuführung der Bauelemente zur Handhabungsvorrichtung 4 nicht über die Transporteinheit 3 in Form einer Pick and Place-Einheit erfolgen, sondern kann auch, wie dem Fachmann bekannt ist, über Schwerkraft erfolgen. In diesem Fall handelt es sich um einen sogenannten Gravityhandler. Anhand der Figuren 2 bis 16 werden im Folgenden Aufbau und Funktionsweise der erfindungsgemäßen Handhabungsvorrichtung 4 näher beschrieben.

Die Handhabungsvorrichtung 4 weist eine Führungseinrichtung 9 mit zwei kreisringförmigen, stationären Führungen 9a, 9b auf, an denen eine Mehrzahl von Umlaufwagen 10 verschiebbar gelagert sind. Im gezeigten Ausführungsbeispiel bestehend die beiden Führungen 9a, 9b jeweils aus Kreisringen mit gleichem Durchmesser, die in zueinander parallelen, beabstandeten Vertikalebenen angeordnet sind und sich um eine gemeinsame Mittelachse 11 herum erstrecken. Der gegenseitige Abstand der Führungen 9a, 9b entspricht in etwa der Breite der Umlaufwagen 10, die damit seitlich nicht oder nur unwesentlich über die beiden Führungen 9a, 9b hinausragen. Weiterhin besteht jede Führung 9a, 9b aus umlaufenden Stegsegmenten, die in horizontaler Richtung von einer nicht näher dargestellten, die Führungen 9a, 9b haltenden Stützstruktur in Richtung der jeweils gegenüberliegenden Führung vorstehen. Die Führungen 9a, 9b können beispielsweise in unmittelbarer Nachbarschaft von zwei gegenüberliegenden Seitenwänden eines Gehäuses der Handhabungsvorrichtung 4 angeordnet sein.

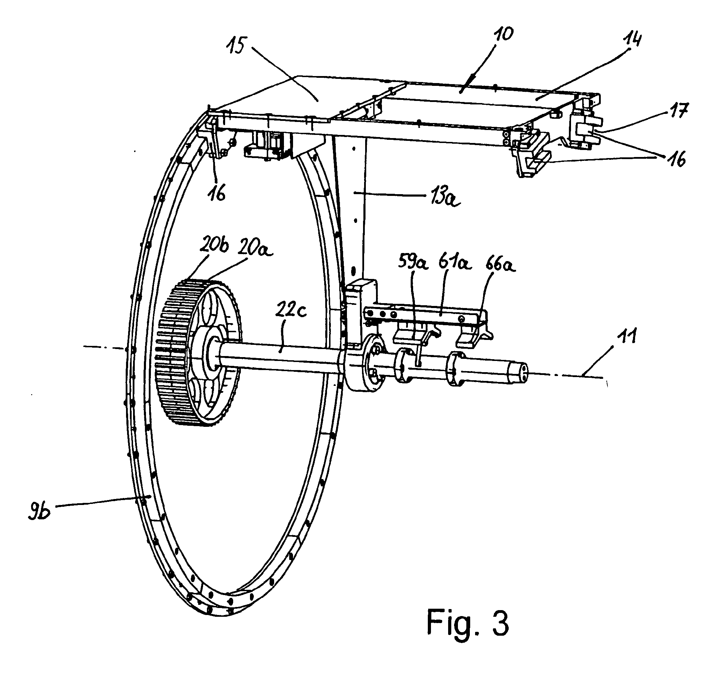

Die Umlaufwagen 10 können längs der Führungen 9a, 9b auf einer Kreisbahn um die horizontale Mittelachse 11 herum unabhängig voneinander geführt werden, d.h. die gegenseitigen Abstände der Umlaufwagen 10 können in Umlaufrichtung variiert werden. Im Ausführungsbeispiel, das anhand der Figuren beschrieben wird, sind drei im Wesentlichen identische Umlaufwagen 10 vorgesehen. In den Figuren 2 und 3 sind nur der Übersichtlichkeit halber lediglich zwei bzw. ein Umlaufwagen 10 eingezeichnet. Je nach Einsatzzweck der Handhabungsvorrichtung kann die Anzahl von Umlaufwagen 10 hiervon jedoch bedeutend abweichen. Beispielsweise ist es möglich zwei bis acht, insbesondere drei bis fünf Umlaufwagen 10 vorzusehen.

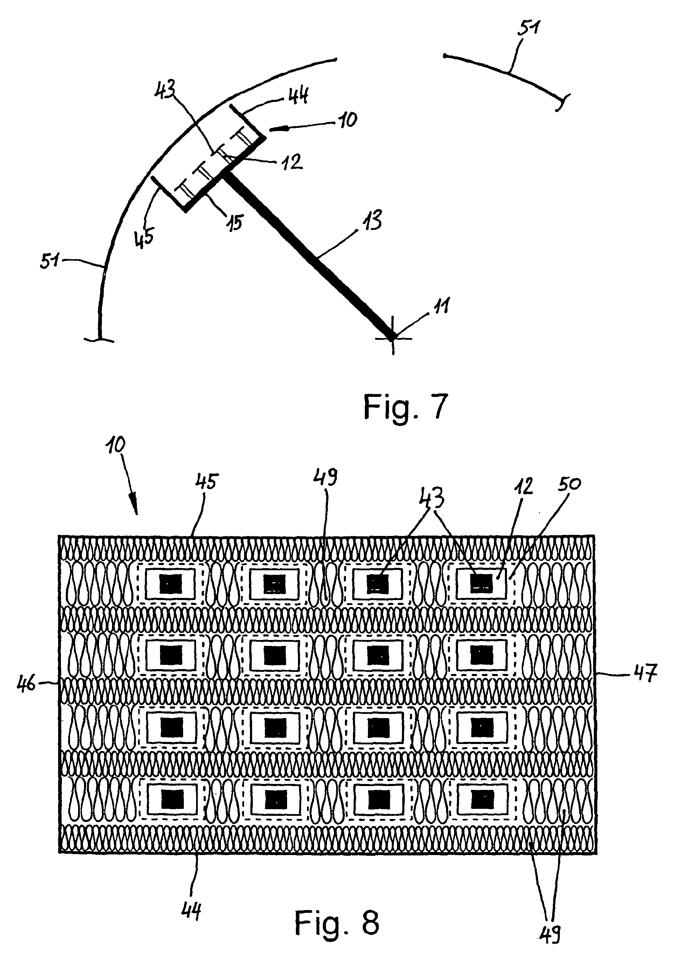

Im dargestellten Ausführungsbeispiel sind, wie in Figur 7 und 8 gezeigt, an jedem Umlaufwagen 10 sechzehn identische Halteeinheiten 12 in der Form von Vakuumsaugern befestigt, die jeweils zum Halten eines zu testenden elektronischen Bauelements 43, beispielsweise eines Halbleiterbauelements (IC), dienen. In den Figuren 2 bis 6 sind lediglich der Übersichtlichkeit halber und um dahinter angeordnete Bauelemente zu zeigen, weniger oder überhaupt keine Halteeinheiten 12 eingezeichnet. Es ist jedoch ohne weiteres möglich, an jedem der Umlaufwagen 10 eine andere Anzahl von Halteeinheiten 12 vorzusehen, um eine entsprechende Anzahl von Bauelementen 43 gleichzeitig aufnehmen, zum Testkopf 5 transportieren und von diesem wieder entfernen zu können, wodurch besonders hohe Durchsätze erreicht werden können. Besonders zweckmäßig kann es sein, die Halteeinheiten 12 matrixförmig auf dem Umlaufwagen 10 anzuordnen, beispielsweise in Form einer 3 x 3, 2 x 4, 4 x 4 oder 5 x 5 Matrix.

Besonders zweckmäßig ist es, wenn die Halteeinheiten 12 unabhängig voneinander, d.h. einzeln, aktiviert werden können. Es ist dann möglich, einzelne Halteeinheiten 12 eines Umlaufwagens 10 nicht mit einem Bauelement 43 zu bestücken und nur eine Untergruppe von Halteeinheiten 12 oder auch nur eine einzige Halteeinheit 12 für den Test zu verwenden.

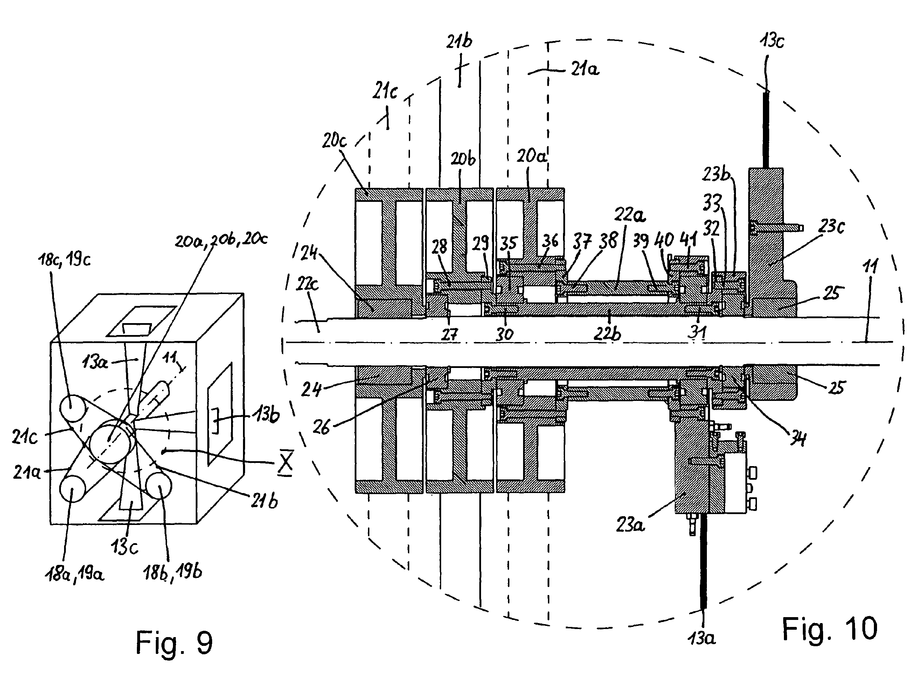

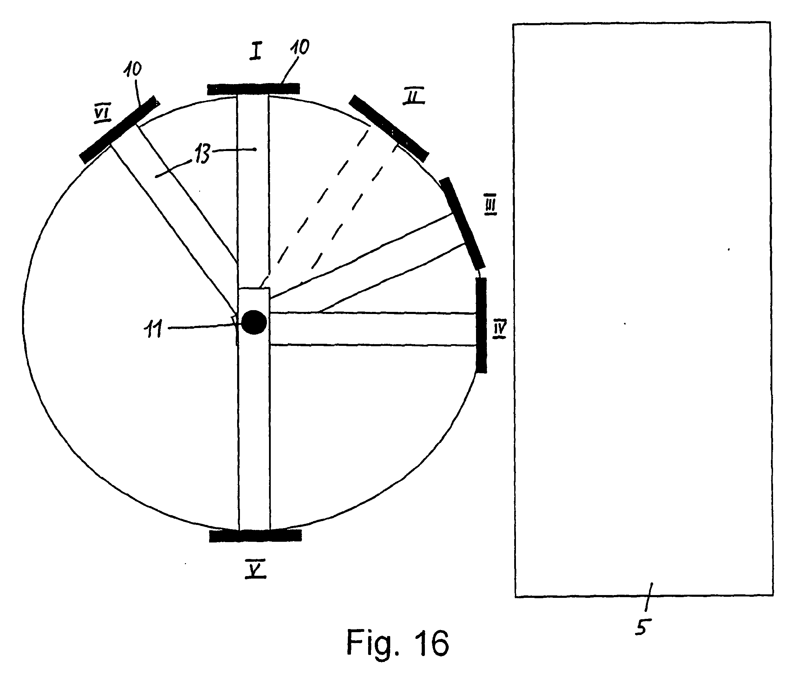

In den schematischen Skizzen der Figuren 1 und 9 sind nicht die Umlaufwagen 10 als solche, sondern lediglich zugeordnete Antriebsarme 13 (die einzelnen Antriebsarme sind mit 13a, 13b, 13c bezeichnet) dargestellt, die sich von der Mittelachse 11 aus radial nach außen zu jeweils einem Umlaufwagen 10 erstrecken und diesen in Umlaufrichtung antreiben. Die Umlaufwagen 10 können, wie später noch anhand von Figur 16 erläutert wird, unabhängig voneinander einzelne Positionen längs der Umlaufbahn anfahren, so dass Totzeiten, d.h. Zeiten, in denen keine Bauelemente mit dem Testkopf 5 kontaktiert sind, minimiert und der Durchsatz durch die Handhabungsvorrichtung 4 erhöht werden können.

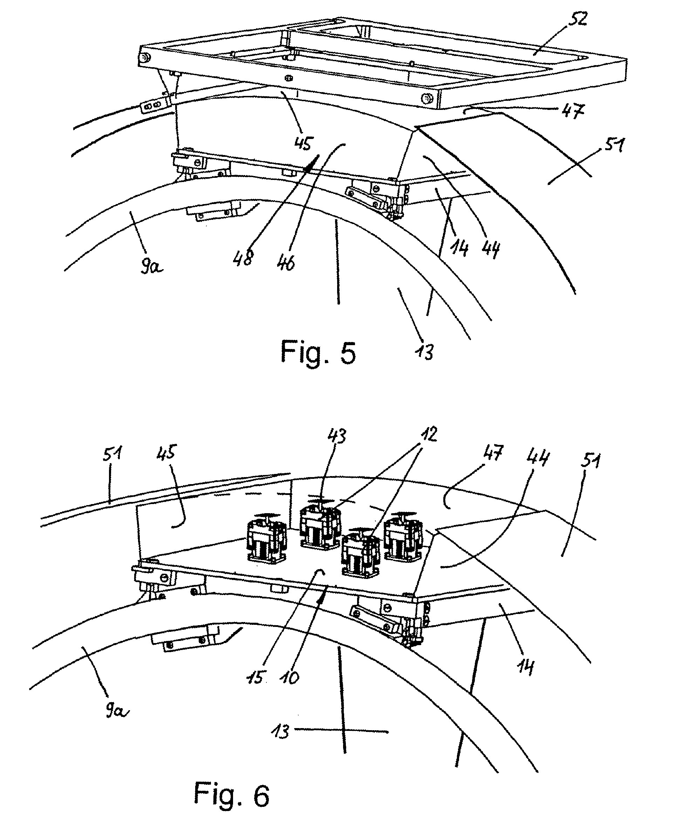

Die Umlaufwagen 10 weisen einen rechteckigen Rahmen 14 auf, auf dem eine zweigeteilte Bodenplatte 15 festgeschraubt ist. In Figur 2 ist der seitliche Umlaufwagen 10 nur mit einer Hälfte der Bodenplatte 15 dargestellt, um den Blick auf die dahinter liegenden Teile zu ermöglichen. In den Figuren 3 und 6 ist ebenfalls nur eine der beiden Plattenhälften dargestellt. Die Bodenplatte 15 dient insbesondere zum Befestigen der Halteeinheiten 12 und ist bodenseitiger Teil einer Temperierkammer, in der die Bauelemente 43 temperiert werden können.

Wie aus den Figuren 2 und 3 ersichtlich, sind an den beiden gegenüberliegenden Seiten des Rahmens 14 jeweils zwei Führungsbacken 16 befestigt, welche die Führungen 9a, 9b übergreifen. Die Führungsbacken 16 haben einen U-förmigen Querschnitt, wobei ihre offene Seite seitlich nach außen zeigt. Die Führungsnuten 17 der Führungsbacken 16 (Figur 3) sind derart auf das Profil der Führungen 9a, 9b abgestimmt, dass die Umlaufwagen 10 nahezu spielfrei an den Führungen 9a, 9b geführt sind.

Die lösbare Befestigung der Bodenplatte 15 auf dem Rahmen 14 bietet den Vorteil, dass die Bodenplatte 15 zusammen mit den Halteeinheiten 12 auf einfache Weise ausgetauscht werden kann, falls beispielsweise eine Anpassung an eine andere Umgebungsstruktur erforderlich wird.

Wie aus den Figuren 5 bis 7 ersichtlich, weist jeder Umlaufwagen 10 eine Temperierkammer mit einem Gehäuse 48 auf, das aus der Bodenplatte 15, einer vorderen Wand 44, einer hinteren Wand 45 sowie zwei Seitenwänden 46, 47 besteht. Die Wände 44-47 bilden zusammen mit der ebenen Bodenplatte 15 ein wannenartiges Gebilde, das seitlich und radial nach innen zumindest im Wesentlichen geschlossen, radial nach außen jedoch, d.h. in den Figuren 5 und 6 nach oben, geöffnet ist. Derjenige Teil der Halteeinheiten 12, der beispielsweise in Figur 6 dargestellt ist, befindet sich vollständig innerhalb des Gehäuses 48.

Die Temperierung der Bauelemente 43 erfolgt zweckmäßigerweise über ein Fluid, das längs der Antriebsarme 13 zu den einzelnen Halteeinheiten 12 und damit gezielt zu den einzelnen Bauelementen 43 geleitet wird. Der Zwischenraum zwischen den einzelnen Halteeinheiten 12 ist, wie in Figur 8 schematisch dargestellt, mittels Wärmedämmmaterial 49 ausgefüllt, so dass um die einzelnen Halteeinheiten 12 herum kleine Einzelkammern 50 gebildet werden, deren Seitenwände nur einen geringen Abstand zu den Halteeinheiten 12 aufweisen. Alternativ ist es jedoch auch möglich, lediglich die Wände 44-47 entsprechend zu isolieren.

Damit beim Temperieren der Bauelemente 43 die Wärme nicht unkontrolliert radial nach außen aus den Temperierkammern abströmt, ist mit geringem radialen Abstand außerhalb der Umlaufwagen 10 eine umlaufende Abdeckung 51 in der Form eines stationären, ringförmigen Abdeckblechs angeordnet. Die Abdeckung 51 überdeckt die Umlaufwagen 10 über ihren gesamten Umlaufweg mit Ausnahme in denjenigen Bereichen, in denen die Umlaufwagen 10 mit Bauelementen 43 beladen, entladen und in Richtung zur Testvorrichtung radial nach außen geschoben werden. In den-Figuren 5 und 6 ist die Beladestation gezeigt, in der die Abdeckbleche in Umlaufrichtung soweit voneinander beabstandet sind, dass die Bauelemente 43 behinderungsfrei auf die zugeordneten Halteeinheiten 12 aufgesetzt werden können.

In Figur 5 ist darüber hinaus noch ein stationärer Rahmen 52 eingezeichnet, der oberhalb der Beladeöffnung angeordnet ist. Im Rahmen der vorliegenden Erfindung hat dieser Rahmen jedoch keine ausschlaggebende Bedeutung.

Jeder Umlaufwagen 10 kann von einem eigenen Antriebsarm 13 längs der Führungen 9a, 9b in Umlauf versetzt werden. Bei den Antriebsarmen 13 handelt es sich um stabile Blechteile, die in Antriebs- bzw. Umlaufrichtung sehr steif ausgebildet sind. In Seitenrichtung müssen die Antriebsarme 13 dagegen keine besondere Stabilität aufweisen, da sie keine Tragefunktion oder seitliche Führungsfunktion für die Umlaufwagen 10 übernehmen müssen. Die Blechdicke kann daher entsprechend gering sein, so dass die Antriebsarme 13 eine geringe Masse aufweisen können. Zusätzlich erreicht man mit derartigen Antriebsarmen 13 einen seitlichen Toleranzausgleich. Die Antriebsarme 13 sind im Bereich zwischen den beiden Führungen 9a, 9b angeordnet und erstrecken sich von der radial inneren Seite der Umlaufwagen 10 in Richtung zur Mittelachse 11.

Wie insbesondere aus den Figuren 2, 4 und 10 ersichtlich, wird jeder Antriebsarm 13a, 13b, 13c von einer eigenen Antriebseinrichtung angetrieben, um die Umlaufwagen 10 unabhängig voneinander bewegen zu können.

Die Antriebseinrichtung für den Antriebsarm 13a umfasst im Wesentlichen einen Antriebsmotor 18a, ein von diesem angetriebenes Antriebszahnrad 19a, ein zentrales Zahnrad 20a, das mit dem Antriebszahnrad 19a über einen Zahnriemen 21a in Drehverbindung ist, und eine Antriebswelle 22a, die einerseits mit dem zentralen Zahnrad 20a und andererseits mit einem Kopplungsteil 23a des Antriebsarms 13a in drehfester Verbindung ist.

Die Antriebseinrichtung für den Antriebsarm 13b umfasst einen Antriebsmotor 18b, ein von diesem in Umdrehung versetzbares Antriebszahnrad 19b, ein zentrales Zahnrad 20b, das mit dem Antriebszahnrad 19b über einen Zahnriemen 21b in Drehverbindung ist, sowie eine Antriebswelle 22b, die einerseits mit dem zentralen Zahnrad 20b und andererseits mit einem Kopplungsteil 23b des Antriebsarms 13b in drehfester Verbindung ist.

Die Antriebseinrichtung für den Antriebsarm 13c umfasst einen Antriebsmotor 18c, ein von diesem in Umdrehung versetzbares Antriebszahnrad 19c, ein zentrales Zahnrad 20c, das über einen Zahnriemen 21c mit dem Antriebszahnrad 19c in Drehverbindung ist, sowie eine Antriebswelle 22c, die einerseits mit dem zentralen Zahnrad 20c und andererseits mit einem Kopplungsteil 23c des Antriebsarms 13c in drehfester Verbindung ist.

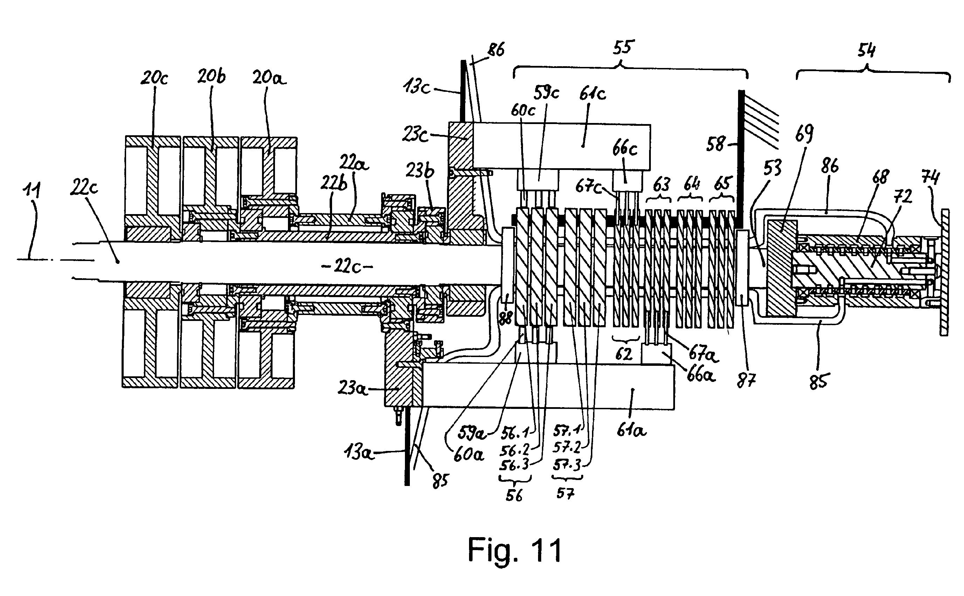

Die drei Antriebswellen 22a, 22b, 22c sind, wie aus den Figuren 10 und 11 ersichtlich, ineinander angeordnet und um die gemeinsame horizontale Mittelachse 11 herum drehbar. Die Antriebswelle 22c stellt die innerste Antriebswelle dar und ist in ihrem in Figur 11 linken Endbereich in einer nicht näher dargestellten Weise am Rahmen der Handhabungsvorrichtung 4 gelagert. Am rechten Ende 53 der innersten Antriebswelle 22c ist ein Lagerring 69 befestigt, der die Antriebswelle 22c an einer feststehenden Stützstruktur der Handhabungsvorrichtung drehbar abstützt. Am Lagerring 69 ist eine fluchtend zur Antriebswelle 22c angeordnete, im Wesentlichen zylinderförmige Vakuum-/ Fluidübertragungseinrichtung 54 angeflanscht, die nachfolgend noch näher beschrieben wird.

Die drehfeste Verbindung zwischen dem zentralen Zahnrad 20c und der innersten Antriebswelle 22c kann, wie in Figur 10 dargestellt, mittels einer Nut-Federverbindung bewirkt werden, wobei Federelemente 24 in entsprechende Nuten eingreifen, die einerseits im zentralen Zahnrad 20c und andererseits in der Antriebswelle 22c vorgesehen sind. Alternativ sind auch andere Verbindungen denkbar, insbesondere Spanneinrichtungen zwischen Antriebswelle 22c und Zahnrad 20c.

In gleicher Weise kann die drehfeste Verbindung zwischen dem Kopplungsteil 23c des Antriebsarms 13c und der innersten Antriebswelle 22a mittels einer Nut-Federverbindung erfolgen, wobei Federelemente 25 in entsprechende Nuten eingreifen, die einerseits am Kopplungsteil 23c und andererseits an der Antriebswelle 22c vorgesehen sind.

Das zentrale Zahnrad 20b ist auf der innersten Antriebswelle 22c drehbar gelagert und in unmittelbarer Nachbarschaft zum zentralen Zahnrad 20c angeordnet. Die Lagerung des zentralen Zahnrads 20b erfolgt im gezeigten Ausführungsbeispiel mittels Kugellager 26. Die innere Lagerschale des Kugellagers 26 ist dabei einerseits durch Anlage am zentralen Zahnrad 20c und andererseits mittels eines Anschlagrings 27 axial festgelegt, der in einer radial umlaufenden Nut der innersten Antriebswelle 22c liegt.

Das zentrale Zahnrad 20b ist über Schrauben 28 mit einem Flanschteil 29 und dieses mittels Schrauben 30 mit der Antriebswelle 22b drehfest verbunden. Diese mittlere Antriebswelle 22b ist rohrförmig ausgebildet und umgibt die innerste Antriebswelle 22a mit etwas Spiel, so dass die mittlere Antriebswelle 22b relativ zur innersten Antriebswelle 22c drehbar ist.

Am gegenüber liegenden Ende ist die mittlere Antriebswelle 22b wiederum mittels Schrauben 31 mit einem Flanschteil 32 und dieses mittels Schrauben 33 mit dem Kopplungsteil 23b drehfest verbunden. Das Kopplungsteil 23b ist wiederum mittels eines Kugellagers 34 drehbar auf der innersten Antriebswelle 22c gelagert.

Das zentrale Zahnrad 20a ist wiederum in unmittelbarer Nachbarschaft seitlich neben dem zentralen Zahnrad 20b angeordnet und mittels eines Kugellagers 35 drehbar auf der mittleren Antriebswelle 22b gelagert. Das zentrale Zahnrad 20a ist mittels Schrauben 36 mit einem Flanschteil 37 und dieses mittels Schrauben 38 mit der Antriebswelle 22a drehfest verbunden. Die rohrförmig ausgebildete Antriebswelle 22a umgibt die mittlere Antriebswelle 22b mit radialem Spiel und ist relativ zu dieser drehbar. Am gegenüber liegenden Ende ist die Antriebswelle 22a mittels Schrauben 39 mit einem Flanschteil 40 und dieses mittels Schrauben 41 mit dem Kopplungsteil 23a des Antriebsarms 13a drehfest verbunden.

Aus den Figuren 10 und 11 ist ersichtlich, dass einerseits die zentralen Zahnräder 20a, 20b, 20c und andererseits die Antriebsarme 13a, 13b, 13c in unmittelbarer Nachbarschaft nebeneinander angeordnet sind, so dass eine sehr kompakte Antriebseinheit erzielt werden kann, die eine voneinander unabhängige Bewegung der einzelnen Antriebsarme 13a, 13b, 13c und damit der Umlaufwagen 10 ermöglicht.

Es ist für den Fachmann ohne weiteres erkennbar, dass in der beschriebenen Weise nicht nur drei Antriebswellen, sondern ohne großen konstruktiven Zusatzaufwand auch vier oder mehr Antriebswellen ineinander angeordnet werden können, falls vier oder mehr Umlaufwagen 10 unabhängig voneinander mittels eigener Antriebsmittel angetrieben werden sollen.

Wie aus Figur 11 ersichtlich, ist im Bereich der innersten Antriebswelle 22c zwischen den Antriebsarmen 13 und der Vakuum-/Fluidübertragungseinrichtung 54 eine elektrische Leistungs-/Datenübertragungseinrichtung 55 angeordnet, über welche einerseits die Umlaufwagen 10 mit Strom versorgt und andererseits ein Datenaustausch zwischen Einrichtungen, die im Bereich der Umlaufwagen 10 angeordnet sind, und einer Datenverarbeitungsanlage erfolgen kann. Elektrischer Strom wird an unterschiedlichen Stellen der Umlaufwagen 10 benötigt, beispielsweise zur Temperierung bzw. Erhitzung von Heizwendeln an den Halteeinheiten 12 (Vakuumsaugern), zur Steuerung von Vakuumventilen, die an den einzelnen Halteeinheiten 12 vorgesehen sind (wenn beispielsweise eine oder mehrere Halteeinheiten 12 nicht verwendet werden sollen), für die Stromversorgung von CAN (Controller Area Network) -Boards, die an den Umlaufwagen 10 angebracht sind, und zur Steuerung von Ventilen für die Heizung und für die Druckversorgung an den einzelnen Vakuumsaugern.

Der Datenaustausch über die Datenübertragungseinrichtung dient unterschiedlichen Zwecken, insbesondere der Übertragung von Daten von Temperatur- und Vakuumsensoren an den Vakuumsaugern sowie zur Kommunikation der CAN-Boards mit der Datenverarbeitungseinrichtung.

Die elektrische Leistungsübertragungseinrichtung weist in dem in Figur 11 dargestellten Ausführungsbeispiel zwei Schleifringgruppen 56, 57 mit jeweils drei Schleifringen 56.1, 56.2, 56.3 bzw. 57.1, 57.2, 57.3 auf. Im vorliegenden Fall sind zwei Schleifringgruppen vorgesehen, um (optional) mit zwei unterschiedlichen Spannungen, beispielsweise mit 24 und 48 Volt, arbeiten zu können. In Figur 11 wird nur die linke Schleifringgruppe 56 benutzt. Im Folgenden wird daher nur die Schleifringgruppe 56 beschrieben.

Die Schleifringgruppe 56 weist drei Schleifringe 56.1, 56.2, 56.3 auf, da eine dreiadrige Stromleitung verwendet wird. Jeder Schleifring ist einer bestimmten Ader zugeordnet. Die einzelnen Schleifringe sind nebeneinander längs der inneren Antriebswelle 22c um die gemeinsame Mittelachse 11 herum stationär innerhalb der Handhabungsvorrichtung angeordnet und mit den einzelnen Adern eines CAN-Busses 58 verbunden. Die Schleifringe werden zentral von der Antriebswelle 22c durchdrungen, wobei sich die Antriebswelle 22c relativ zu den ortsfesten Schleifringen drehen kann.

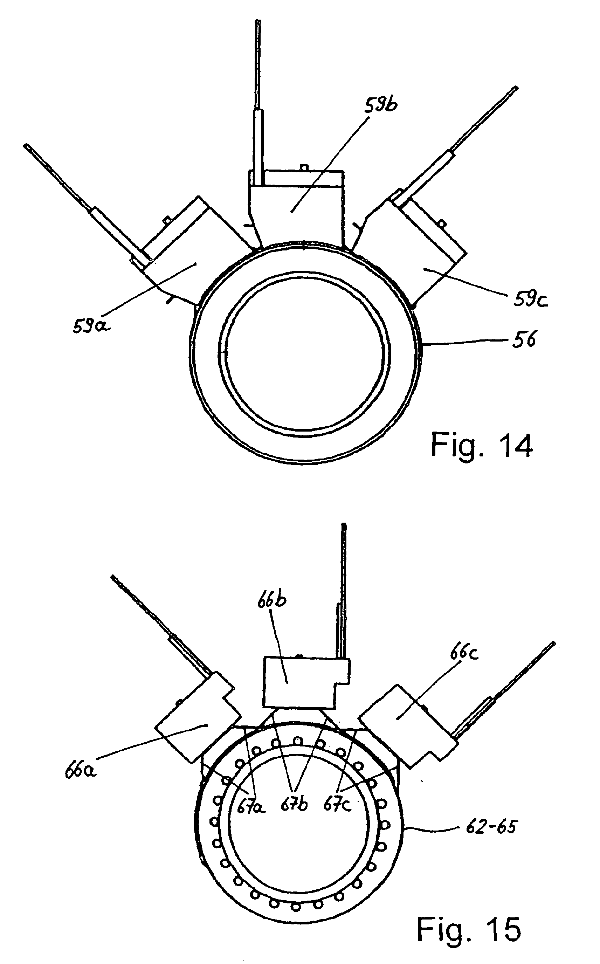

Jeder Schleifring 56.1, 56.2, 56.3 ist mit einer der Anzahl von Umlaufwagen 10 entsprechenden Anzahl von Schleifbürstenblöcken 59a, 59b, 59c in Kontakt (siehe auch Figur 14). Da im vorliegenden Fall drei Umlaufwagen 10 vorhanden sind, sind somit drei Schleifbürstenblöcke 59a, 59b, 59c vorhanden, die an verschiedenen Stellen längs des Umfanges der Schleifringe 56.1, 56.2, 56.3 angeordnet sind.

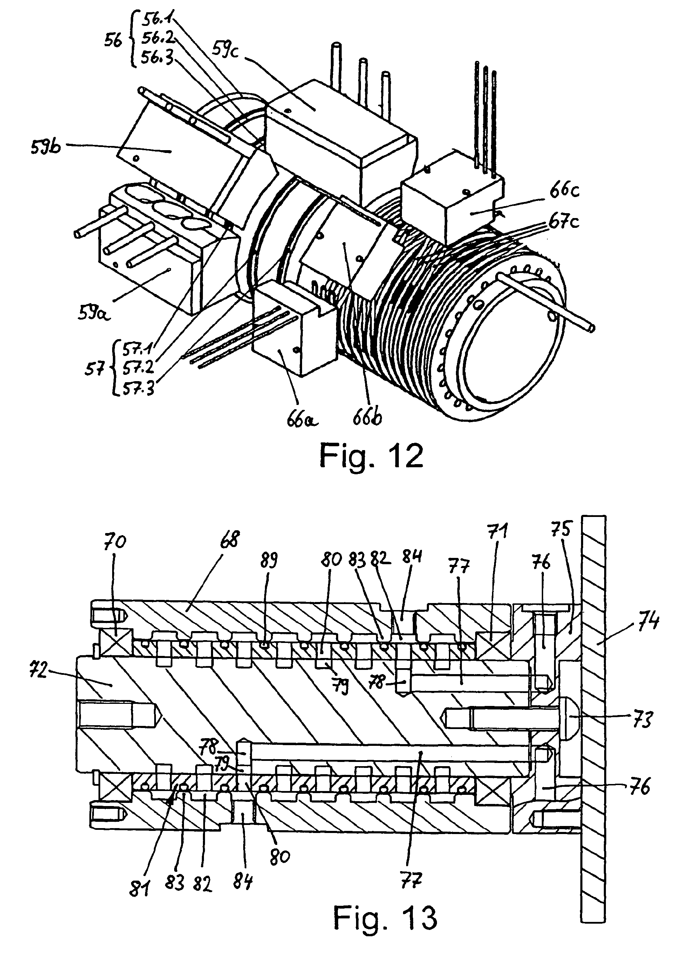

In Figur 12 ist abweichend zum Ausführungsbeispiel von Figur 11 der Schleifringblock 59c nicht mit der Schleifringgruppe 56, sondern mit der Schleifringgruppe 57 in Kontakt. Wird jedoch nur diejenige Spannung verwendet, die der Schleifringgruppe 56 zugeordnet ist, befindet sich auch der Schleifbürstenblock 59c in gleicher Weise wie die Schleifbürstenblöcke 59a, 59b auf der Schleifringgruppe 56. Jeder Schleifbürstenblock 59a, 59b, 59c weist eine dreiadrige Schleifbürste 60a, 60b, 60c auf, die mit den zugeordneten Schleifringen 56.1, 56.2, 56.3 in Kontakt sind und in bekannter Weise auf der Außenumfangsfläche der zugeordneten Schleifringe gleiten können.

Die Schleifbürstenblöcke 59a, 59b, 59c sind jeweils an zugeordneten Haltebrücken 61a, 61b, 61c befestigt, die wiederum an den zugehörigen Kopplungsteilen 23a, 23b, 23c der Antriebsarme 13a, 13b, 13c befestigt sind. Werden die Antriebsarme 13a, 13b, 13c in Umdrehung versetzt, bewegen sich damit auch die Schleifbürstenblöcke 59a, 59b, 59c mit den zugeordneten Schleifbürsten über den Umfang der stationären Schleifringe 56.1, 56.2, 56.3, wobei sie eine kontinuierliche Stromübertragung von einer stationären Stromerzeugungsquelle zu den einzelnen Umlaufwagen 10 sicher stellen.

Die Datenübertragung zu den einzelnen Umlaufwagen erfolgt in ähnlicher Weise wie die vorstehend beschriebene elektrische Leistungsübertragung. Hierzu sind, wie aus den Figuren 11 und 12 ersichtlich, vier Schleifringgruppen 62, 63, 64, 65 vorgesehen. Jede dieser Schleifringgruppen weist drei Schleifringe auf. Auch diese Schleifringe sind in gleicher Weise wie diejenigen der elektrischen Leistungsübertragungseinrichtung nebeneinander um die Mittelachse 11 herum, d.h. um die innere Antriebswelle 22c herum, und stationär innerhalb der Handhabungsvorrichtung angeordnet. Jede Schleifringgruppe 62, 63, 64, 65 weist drei Schleifringe auf, um jeweils drei unterschiedliche Adern einer Datenleitung, die im CAN-Bus 58 integriert ist, kontaktieren zu können.

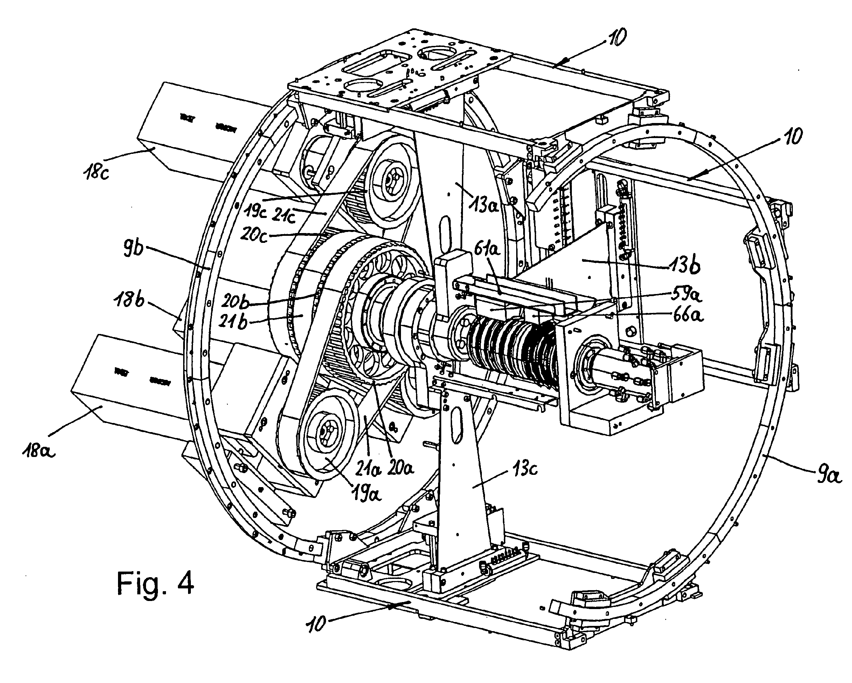

Wie beispielsweise aus den Figuren 4, 11, 12 und 15 ersichtlich, ist an den Haltebrücken 61a, 61b, 61c der einzelnen Antriebsarme 13a, 13b, 13c jeweils ein Schleiffederblock 66a, 66b, 66c befestigt, dessen Schleiffedern 67a, 67b, 67c auf den Schleifringgruppen 62, 63, 64 aufliegen, wie in Figur 12 dargestellt. Die Schleiffedern 67a, 67b, 67c bleiben beim Drehen der Antriebsarme 13a, 13b, 13c in Schleifkontakt mit den zugeordneten Schleifringen und ermöglichen auf diese Weise die Datenübertragung von den rotierenden Umlaufwagen 10 zu einer stationären Datenverarbeitungseinrichtung über den CAN-Bus 58.

Die Schleifbürstenblöcke 59a, 59b, 59c der elektrischen Leistungsübertragungseinrichtung und die Schleiffederblöcke 66a, 66b, 66c der Datenübertragungseinrichtung sind derart über den Umfang der Schleifringe angeordnet, dass sie sich gegenseitig nicht stören, wenn die zugeordneten Umlaufwagen 10 relativ zueinander bewegt werden, so dass sich ihre gegenseitigen Abstände längs der Umlaufbahn ändern.

Im Folgenden wird anhand der Figuren 11 und 13 die Vakuum-/Fluidübertragungseinrichtung 54 näher beschrieben.

Die Vakuum-/Fluidübertragungseinrichtung 54 weist ein zylinderförmiges Gehäuse 68 auf, das stirnseitig am Lagerring 69 festgeschraubt und über diesen mit der inneren Antriebswelle 22c fest verbunden ist. Das Gehäuse 68 ist hülsenförmig ausgebildet und an den beiden gegenüberliegenden Enden mittels Lagern 71 drehbar auf einem stationären, zylinderförmigen Zentralteil 72 gelagert. Das Zentralteil 72 ist mittels einer Schraube 73 an einem Flanschteil 74 befestigt, das wiederum an einer ortsfesten Stützstruktur der Handhabungsvorrichtung festgeschraubt werden kann.

Die Vakuum-/Fluidübertragungseinrichtung 54 weist insgesamt acht Kanäle auf, um insgesamt maximal vier Umlaufwagen 10 sowohl mit Vakuum zum Festsaugen der Bauelemente 43 auf den Druckstößeln 42 als auch mit Fluid, insbesondere in Form von gereinigter Luft, zu versorgen, mit dem die festgesaugten Bauelemente 43 temperiert werden. Hierzu sind in einem zylindrischen Abschnitt 75 des Flanschteils 74 insgesamt acht über den Umfang verteilte Radialbohrungen 76 vorgesehen, die an entsprechende Leitungen einer Fluid- bzw. Vakuumversorgungsquelle der Handhabungsvorrichtung angeschlossen sind. Die Radialbohrungen 76 münden in acht zugeordnete, unterschiedlich lange Axialbohrungen 77 und diese wiederum in Radialbohrungen 78, die innerhalb des Zentralteils 72 vorgesehen sind. Die Radialbohrungen 78 münden in zugeordnete Ringnuten 79, die sich am außenumfang des Zentralteils 72 befinden. Jede der acht Ringnuten 79 ist mit zugeordneten Radialbohrungen 80 in Fluidverbindung, die sich in einer Buchse 81 befinden, die in einem Zwischenraum zwischen dem Zentralteil 72 und dem Gehäuse 68 angeordnet ist und fest auf dem Zentralteil 72 sitzt. Die Radialbohrungen 80 sind als Durchgangsbohrungen ausgebildet und münden in Ringkammern 82, die an der inneren Umfangswand des Gehäuses 68 umlaufend ausgebildet und durch nach innen vorstehende, umlaufende Stege 83 voneinander getrennt sind. Dichtringe 89, die mit den Stegen 83 zusammenwirken, sorgen für eine fluiddichte Trennung der einzelnen Ringkammern 82. Jede Ringkammer 82 ist mit einem durchgehenden radialen Durchlass 84 in Verbindung, in dem ein entsprechendes Anschlussstück einer Vakuumleitung 85 (Figur 11) bzw. Fluidversorgungsleitung 86 eingeschraubt werden kann.

Wie aus Figur 11 ersichtlich, können die Vakuumleitungen 85 und die Fluidversorgungsleitungen 86, die sich zusammen mit dem Gehäuse 68 der Vakuum-/Fluidübertragungseinrichtung 54 und damit zusammen mit der inneren Antriebswelle 22c drehen und damit relativ zur Antriebswelle 22c stationär sind, nahe der Antriebswelle 22c durch die Schleifringe und durch zwei auf der Antriebswelle 22c befestigte Halteringe 87, 88 hindurchgeführt und auf diese Weise zu den einzelnen Antriebsarmen 13a, 13b, 13c geführt werden.

Anhand von Figur 16 wird im Folgenden die Funktionsweise der erfindungsgemäßen Handhabungsvorrichtung 4 beispielhaft beschrieben. In der Position I, die der 12-Uhr Position entspricht und die Beladestation zeigt, befindet sich ein Umlaufwagen 10 in der Beladeposition, in der die zu testenden Bauelemente von der Transporteinheit 3 (Pickand Place-Einheit) auf die einzelnen Halteeinheiten 12 übergeben werden. Die Halteeinheiten 12 weisen hierzu Druckstößel 42 auf. Die Bauelemente werden in der Position I auf die äußeren Enden der Druckstößel 42 aufgesetzt, wo sie mittels Vakuum festgesaugt werden. Die Bauelemente liegen hierbei parallel zur Bodenplatte 15.

Wenn alle Halteeinheiten 12 mit einem Bauelement bestückt sind, kann der Umlaufwagen 10 mittels der dazu gehörigen Antriebseinrichtung um beispielsweise 15° im Uhrzeigersinn in eine Position II (Ausrichtstation) weiter gedreht werden, um dort, falls erforderlich, eine Ausrichtung der Bauelemente (alignment) durchzuführen.

Ist dieser Vorgang abgeschlossen, kann der Umlaufwagen 10 beispielsweise um weitere 15° in eine Position III (Wartestation) weiter gedreht werden, die einer Warteposition entspricht. In dieser Position III wartet der Umlaufwagen 10 so lange, bis ein anderer Umlaufwagen 10 eine Position IV verlassen hat, die einer 3-Uhr Position entspricht.

Die Position IV (Teststation) ist eine Position, in der der Antriebsarm 13 eine horizontale Stellung und der Umlaufwagen 10 eine vertikale Stellung einnimmt. In der Position IV werden die Bauelemente in horizontaler Richtung dem Testkopf 5 zugeführt, um die Bauelemente mit dem Testkopf 5 zu kontaktieren, und nach Beendigung des Tests wieder in horizontaler Richtung vom Testkopf 5 entfernt. Das Zuführen und Entfernen der Bauelemente zum bzw. vom Testkopf 5 erfolgt dabei mittels der Druckstößel 42, indem die Druckstößel 42 relativ zur übrigen Halteeinheit 12 ausgefahren bzw. zurückgezogen werden. In Figur 2 ist derjenige Druckstößel 42, der sich am seitlichen Umlaufwagen 10 befindet, in der ausgefahrenen Position eingezeichnet, während die beiden Druckstößel 42 des oberen Umlaufwagens 10 in der eingefahrenen Position dargestellt sind. Zum Ausfahren der Druckstößel 42 ist im Bereich zwischen den Antriebswellen 22 und dem sich in der seitlichen Position befindenden Umlaufwagen 10 eine in den Figuren nicht dargestellte, Stößelvorschubeinrichtung vorgesehen, die mit dem rückseitigen Ende der Druckstößel 42 zusammenwirkt. Die Bodenplatte 15 weist hierzu im Bereich der Druckstößel 42 entsprechende Öffnungen auf. Werden die Druckstößel 42 nach vorne gedrückt, können die am vorderen Ende der Druckstößel 42 gehalterten Bauelemente mit entsprechenden Kontakten des Testkopfs 5 in Kontakt gebracht werden, so dass die elektrischen Messungen durchgeführt werden können. Nach Beendigung des Tests werden die Druckstößel 42 mittels Federkraft in ihre zurückgezogene Ausgangsstellung zurückgezogen.

Nach Beendigung des Tests wird der Umlaufwagen 10 von der Position IV in eine Position V weiter gedreht, in der die getesteten Bauelemente mittels der Entnahmeeinheit 6 (Figur 1) aus der Handhabungsvorrichtung 4 entnommen werden. Die Position V liegt bei dem gezeigten Ausführungsbeispiel in der 6-Uhr Position.

Nachdem ein Umlaufwagen 10 die Position IV verlassen hat, kann ein nachfolgender Umlaufwagen 10, der bereits in unmittelbarer Nachbarschaft zur Position IV wartet, in kürzester Zeit in die Position IV überführt werden.

Nach dem Entladen der Bauelemente kann ein Umlaufwagen 10 weiter in die Position VI überführt werden, die sich in unmittelbarer Nachbarschaft zur Position I befindet und beispielsweise in etwa einer 11-Uhr Position entspricht. Die Position VI ist wiederum eine Warteposition. In dieser Warteposition wartet der Umlaufwagen 10 so lange, bis ein anderer Umlaufwagen, der sich gerade in der Position I befindet und beladen wird, den Beladevorgang abgeschlossen und die Position I verlassen hat. Sobald die Position I frei geworden ist, kann der Umlaufwagen 10 von der Position VI auf kürzestem Weg und mit minimalem Zeitaufwand in die Position I weiter gedreht werden, um dort mit neuen Bauelementen beladen zu werden.

Es ist ersichtlich, dass dann, wenn mehrere unabhängig voneinander bewegbare Umlaufwagen 10 verwendet werden, ein zeitoptimiertes paralleles Arbeiten beim Beladen (Position I), Testen (Position IV) und Entladen der Bauelemente (Position V) erfolgen kann, da bei Vorgängen, die schneller als andere Vorgänge abgeschlossen werden können, die verbleibende Zeit dazu verwendet werden kann, um den betreffenden Umlaufwagen 10 in eine Warteposition unmittelbar vor der nachfolgenden Position zu überführen. Die Bauelemente stehen daher sofort für die nachfolgende Position zur Verfügung, wenn der vorhergehende Umlaufwagen 10 diese Position verlassen hat. Die einzelnen Umlaufwagen 10 können hierbei schrittweise immer in der gleichen Drehrichtung in die jeweils nachfolgende Position weiter gedreht werden. Eine Umkehrung der Drehrichtung ist nicht erforderlich.

Eine sehr genaue Positionierung der Umlaufwagen 10 in den einzelnen Position I-VI kann dadurch erreicht werden, dass an den Umlaufwagen 10 Messstreifen und an der Führungseinrichtung 9 Messköpfe vorgesehen werden, die anhand der Messtreifen die genaue Position der Umlaufwagen feststellen können, so dass die Antriebsmotoren 18a, 18b, 18c veranlasst werden, die Umlaufwagen 10 solange zu bewegen, bis sie die genaue Solllage einnehmen.

## Patentansprüche

1. Handhabungsvorrichtung für elektronische Bauelemente, insbesondere IC's, mit
- einer Mehrzahl von auf einer Umlaufbahn bewegbaren Umlaufeinheiten, die jeweils mindestens eine Halteeinheit (12) zum Halten eines Bauelements (43) aufweisen und zwischen einer Beladestation zum Beladen der Halteinheiten (12) mit den Bauelementen (43), einer Teststation zum Zuführen der Bauelemente (43) zu mit einer Testvorrichtung verbundenen Kontaktiereinrichtungen und einer Entladestation zum Entfernen der Bauelemente (43) von den Halteeinheiten (12) bewegbar sind,
- einer Antriebseinrichtung zum Bewegen der Umlaufeinheiten,
**dadurch gekennzeichnet, dass** die Umlaufeinheiten jeweils mindestens eine Temperierkammer aufweisen, in der sich die an den Halteeinheiten (12) gehalterten Bauelemente (43) befinden, so dass die Bauelemente (43) während des Transports von der Beladestation zur Teststation temperierbar sind.

2. Handhabungsvorrichtung nach Anspruch 1, **dadurch gekennzeichnet, dass** die Temperierkammern wannenförmig ausgebildet sind und jeweils ein Gehäuse (48) mit einer Bodenplatte (15), einer vorderen Wand (44), einer hinteren Wand (45) und Seitenwänden (46, 47) aufweisen, während das Gehäuse (48) radial nach außen geöffnet und zumindest in einem Bereich zwischen der Beladestation und der Teststation von einer konzentrisch zur Kreisbahn angeordneten, stationären Abdeckung (51) überdeckt ist.

3. Handhabungsvorrichtung nach Anspruch 2, **dadurch gekennzeichnet, dass** die Halteeinheiten (12) zum Halten der Bauelemente (43) an der Bodenplatte (15) befestigt sind und relativ zur Bodenplatte (15) verschiebbare Druckstößel (42) umfassen, an deren vorderem Ende jeweils ein Bauelement (43) mittels Unterdruck gehalten wird.

4. Handhabungsvorrichtung nach einem der vorhergehenden Ansprüche, **dadurch gekennzeichnet, dass** innerhalb der Temperierkammern jeweils eine Mehrzahl von Halteeinheiten (12) angeordnet ist, die voneinander durch Wärmedämmmaterial (49) gedämmt sind, so dass jede Halteeinheit (12) oder eine Untergruppe von Halteeinheiten (12) in einer seitlich vom Wärmematerial (49) umgebenen Einzelkammer angeordnet ist.

5. Handhabungsvorrichtung nach einem der Ansprüche 1 bis 4, **dadurch gekennzeichnet, dass** die die Temperierkammern aufweisenden Umlaufeinheiten unabhängig voneinander auf der Kreisbahn bewegbar sind.

6. Handhabungsvorrichtung nach einem der vorhergehenden Ansprüche, **dadurch gekennzeichnet, dass** die Umlaufeinheiten aus Umlaufwagen (10) bestehen, die an einer stationären, kreisringförmigen Führungseinrichtung (9) geführt sind.

7. Handhabungsvorrichtung nach Anspruch 6, **dadurch gekennzeichnet, dass** die Führungseinrichtung (9) aus zwei kreisringförmigen Führungen (9a, 9b) besteht, die seitlich beabstandet in zwei zueinander parallelen Vertikalebenen angeordnet sind.

8. Handhabungsvorrichtung nach Anspruch 6 oder 7, **dadurch gekennzeichnet, dass** die Temperierkammern in ihren gegenüberliegenden Seitenbereichen an der kreisringförmigen Führungseinrichtung (9) gelagert sind.

9. Handhabungsvorrichtung nach einem der vorhergehenden Ansprüche, **dadurch gekennzeichnet, dass** die Antriebseinrichtung zum Bewegen der Umlaufeinheiten eine Mehrzahl von Antriebsmotoren (18a, 18b, 18c) aufweist, wobei jede Umlaufeinheit mit einem eigenen Antriebsmotor (18a, 18b, 18c) in Wirkverbindung steht.

10. Handhabungsvorrichtung nach einem der Ansprüche 6 bis 9, **dadurch gekennzeichnet, dass** jeder Umlaufwagen (10) mittels einer separaten Antriebswelle (22a, 22b, 22c) und eines sich von der Antriebswelle (22a, 22b, 22c) aus zum zugeordneten Umlaufwagen (10) erstreckenden Antriebsarms (13a, 13b, 13c) mit dem zugeordneten Antriebsmotor (18a, 18b, 18c) in Wirkverbindung ist.

11. Handhabungsvorrichtung nach Anspruch 10, **dadurch gekennzeichnet, dass** die Antriebswellen (22a, 22b, 22c) der einzelnen Umlaufwagen (10) ineinander angeordnet und um eine gemeinsame Mittelachse (11) herum drehbar sind.

12. Handhabungsvorrichtung nach Anspruch 11, **dadurch gekennzeichnet, dass** mindestens eine der Antriebswellen (22a, 22b, 22c) als Lagerkonsole für mindestens eine weitere Antriebswelle (22a, 22b, 22c) dient.

13. Handhabungsvorrichtung nach einem der Ansprüche 6 bis 12, **dadurch gekennzeichnet, dass** eine elektrische Leistungsübertragungseinrichtung zur Übertragung elektrischen Stroms zwischen einer stationären Stromerzeugungsquelle und den Umlaufwagen (10) vorgesehen ist, wobei die Leistungsübertragungseinrichtung Schleifringe (56.1, 56.2, 56.3), die längs einer Mittelachse (11) nebeneinander stationär angeordnet sind, und mit den Schleifringen zusammenwirkende Schleifbürsten (60a, 60b, 60c) umfasst, die an den Antriebsarmen (13a, 13b, 13c) befestigt sind.

14. Handhabungsvorrichtung nach Anspruch 13, **dadurch gekennzeichnet, dass** über den Umfang der Schleifringe (56.1, 56.2, 56.3) verteilt mehrere Schleifbürsten (60a, 60b, 60c) angeordnet sind.

15. Handhabungsvorrichtung nach einem der Ansprüche 6 bis 14, **dadurch gekennzeichnet, dass** eine Datenübertragungseinrichtung zur Übertragung von Daten zwischen einer stationären Datenverarbeitungsanlage und den Umlaufwagen (10) vorgesehen ist, wobei die Datenübertragungseinrichtung eine Mehrzahl von Schleifringen aufweisenden Schleifringgruppen (62, 63, 64, 65), die längs einer Mittelachse (11) nebeneinander stationär angeordnet sind, und mit den Schleifringen zusammenwirkende Schleiffedern (67a, 67b, 67c) umfasst, die an den Antriebsarmen (13a, 13b, 13c) befestigt sind.

16. Handhabungsvorrichtung nach Anspruch 15, **dadurch gekennzeichnet, dass** die Schleifringe der elektrischen Leistungsübertragungseinrichtung und der Datenübertragungseinrichtung in enger Nachbarschaft nebeneinander angeordnet sind.

17. Handhabungsvorrichtung nach einem der Ansprüche 9 bis 17, **dadurch gekennzeichnet, dass** eine der Antriebswellen (22a, 22b, 22c) mit einer fluchtend zu dieser angeordneten Vakuum-/Fluidübertragungseinrichtung (54) in Verbindung steht, mit der Vakuum- und/oder Fluid von einer stationären Vakuum- bzw. Fluidversorgungsquelle zu den Halteeinheiten (12) übertragen werden kann.

18. Handhabungsvorrichtung nach Anspruch 17, **dadurch gekennzeichnet, dass** die Vakuum-/Fluidübertragungseinrichtung (54) ein mit der Antriebswelle (22c) drehfest verbundenes Gehäuse (68) und ein innerhalb des Gehäuses (68) angeordnetes, stationär in der Handhabungsvorrichtung befestigbares Zentralteil (72) aufweist, das über Axialbohrungen (77) und diesen zugeordnete Radialbohrungen (78) eine Vakuum- bzw. Fluidverbindung zu radialen Durchlässen (84) des zusammen mit der Antriebswelle (22c) drehbaren Gehäuses (68) schafft.

## Claims

1. Handling device for electronic components, in particular ICs, comprising
- a plurality of circulation units which are movable on a circulation path, each comprise at least one holding unit (12) for holding a component (43), and are movable between a loading station for loading the holding units (12) with the components (43), a test station for moving the components (43) towards contacting means which are connected to a test device, and an unloading station for removing the components (43) from the holding units (12),
- a drive means for moving the circulation units,
**characterised in that** the circulation units each comprise at least one temperature control chamber, in which the components (43) mounted on the holding units (12) are located, in such a way that the components (43) can be temperature-controlled during the transportation from the loading station to the test station.

2. Handling device according to claim 1, **characterised in that** the temperature control chambers are formed so as to be trough-shaped and each comprise a housing (48) having a base plate (15), a front wall (44), a rear wall (45) and side walls (46, 47), whilst the housing (48) is radially outwardly open and covered at least in a region between the loading station and the test station by a stationary cover (51) arranged concentric with the circular path.

3. Handling device according to claim 2, **characterised in that** the holding units (12) for holding the components (43) are fixed to the base plate (15) and comprise plungers (42) which are displaceable relative to the base plate (15) and on the front end of each of which a component (43) is held by negative pressure.

4. Handling device according to any one of the preceding claims, **characterised in that** a plurality of holding units (12) are arranged inside each of the temperature control chambers and are insulated from one another by thermal insulation material (49) in such a way that each holding unit (12) or a sub-group of holding units (12) is arranged in an individual chamber which is laterally surrounded by thermal material (49).

5. Handling device according to any one of claims 1 to 4, **characterised in that** the circulation units comprising the temperature control chambers are movable mutually independently on the circular path.

6. Handling device according to any one of the preceding claims, **characterised in that** the circulation units consist of circulation carriages (10) which are guided on a stationary annular guide means (9).

7. Handling device according to claim 6, **characterised in that** the guide means (9) consists of two annular guides (9a, 9b), which are arranged with lateral spacing in two mutually parallel vertical planes.

8. Handling device according to either claim 6 or claim 7, **characterised in that** the temperature control chambers are mounted, in the opposing side regions thereof, on the annular guide means (9).

9. Handling device according to any one of the preceding claims, **characterised in that** the drive means comprises a plurality of drive motors (18a, 18b, 18c) for moving the circulation units, each circulation unit being in an operative connection with a separate drive motor (18a, 18b, 18c).

10. Handling device according to any one of claims 6 to 9, **characterised in that** each circulation carriage (10) is in an operative connection with the associated drive motor (18a, 18b, 18c) via a separate drive shaft (22a, 22b, 22c) and a drive arm (13a, 13b, 13c) extending out from the drive shaft (22a, 22b, 22c) to the associated circulation carriage (10).

11. Handling device according to claim 10, **characterised in that** the drive shafts (22a, 22b, 22c) of the individual circulation carriages (10) are arranged inside one another and are rotatable about a common central axis (11).

12. Handling device according to claim 11, **characterised in that** at least one of the drive shafts (22a, 22b, 22c) acts as a mounting bracket for at least one further drive shaft (22a, 22b, 22c).

13. Handling device according to any one of claims 6 to 12, **characterised in that** an electrical power transfer means is provided for transferring electrical current between a stationary current generation source and the circulation carriages (10), the power transfer means comprising slip rings (56.1, 56.2, 56.3), which are arranged in a stationary and adjacent manner along a central axis (11), and brushes (60a, 60b, 60c), which cooperate with the slip rings and are fixed to the drive arms (13a, 13b, 13c).

14. Handling device according to claim 13, **characterised in that** a plurality of brushes (60a, 60b, 60c) are arranged distributed over the circumference of the slip rings (56.1, 56.2, 56.3).

15. Handling device according to any one of claims 6 to 14, **characterised in that** a data transmission means is provided for transmitting data between a stationary data processing system and the circulation carriages (10), the data transmission means comprising a plurality of slip ring groups (62, 63, 64, 65), which comprise slip rings and are arranged in a stationary and adjacent manner along a central axis (11), and wipers (67a, 67b, 67c), which cooperate with the slip rings and are fixed to the drive arms (13a, 13b, 13c).

16. Handling device according to claim 15, **characterised in that** the slip rings of the electrical power transfer means and of the data transmission means are arranged in close proximity to one another.

17. Handling device according to any one of claims 9 to 17, **characterised in that** one of the drive shafts (22a, 22b, 22c) is connected to a vacuum/fluid transfer means (54), which is arranged flush therewith and by means of which the vacuum or fluid can be transferred from a stationary vacuum or fluid supply source to the holding units (12).

18. Handling device according to claim 17, **characterised in that** the vacuum/fluid transfer means (54) comprises a housing (68), which is rotationally engaged with the drive shaft (22c), and a central part (72), which is arranged inside the housing (68) and fixed in a stationary manner in the handling device and produces, via axial holes (77) and radial holes (78) associated with said axial holes, a vacuum or fluid connection to radial conduits (84) of the housing (68), which is rotatable together with the drive shaft (22c).

## Revendications

1. Dispositif de manipulation pour composants électroniques, en particulier circuits intégrés, comprenant
- une pluralité d'unités en recirculation mobiles sur une trajectoire de recirculation, qui comprennent chacune au moins une unité de maintien (12) pour maintenir un composant (43) et qui sont déplaçables entre une station de chargement pour charger les unités de maintien (12) avec les composants (43), une station de test pour amener les composants (43) à des systèmes de mise en contact connectés à un dispositif de test, et une station de déchargement pour enlever les composants (43) hors des unités de maintien (12),
- un système d'entraînement pour déplacer les unités en recirculation, **caractérisé en ce que** les unités en recirculation comprennent chacune au moins une chambre de températion, dans laquelle se trouvent les composants (43) maintenu sur les unités de maintien (12), de sorte que les composants (43) peuvent être tempérés pendant le transport de la station de chargement à la station de test.

2. Dispositif de manipulation selon la revendication 1, **caractérisé en ce que** les chambres de températion sont réalisées en forme de cuve et comprennent chacune un boîtier (48) avec une plaque de fond (15), une paroi antérieure (44), une paroi postérieure (45) et des parois latérales (46, 47), tandis que le boîtier (48) est ouvert radialement vers l'extérieur et est recouvert au moins dans une région entre la station de chargement et la station de test par une couverture stationnaire (51) agencée concentriquement à la trajectoire de recirculation.

3. Dispositif de manipulation selon la revendication 2, **caractérisé en ce que** les unités de maintien (12) destinées au maintien des composants (43) sont fixées sur la plaque de fond (15) et comprennent des poussoirs (42) déplaçables par rapport à la plaque de fond (15), à l'extrémité antérieure desquels un composant respectif (43) est maintenu au moyen d'une dépression.

4. Dispositif de manipulation selon l'une des revendications précédentes, **caractérisé en ce qu'**une pluralité d'unités de maintien (12) sont agencées respectivement à l'intérieur des chambres de températion, lesquelles sont isolées les unes des autres par un matériau d'isolation thermique (49), de sorte que chaque unité de maintien (12) ou un sous-groupe d'unités de maintien (12) est agencé(e) dans une chambre individuelle entourée latéralement par un matériau d'isolation thermique (49).

5. Dispositif de manipulation selon l'une des revendications 1 à 4, **caractérisé en ce que** les unités en recirculation qui comportent des chambres de températion sont déplaçables indépendamment les unes des autres sur la trajectoire de recirculation.

6. Dispositif de manipulation selon l'une des revendications précédentes, **caractérisé en ce que** les unités en recirculation sont constituées par des chariots en recirculation (10) qui sont guidés sur un système de guidage stationnaire (9) en forme d'anneau circulaire.

7. Dispositif de manipulation selon la revendication 6, **caractérisé en ce que** le système de guidage (9) est constitué de deux guidages (9a, 9b) en forme d'anneau circulaire, qui sont agencés avec écartement latéral dans deux plans verticaux mutuellement parallèles.

8. Dispositif de manipulation selon la revendication 6 ou 7, **caractérisé en ce que** les chambres de températion sont montées dans leurs zones latérales opposées sur le système de guidage (9) en forme d'anneau circulaire.

9. Dispositif de manipulation selon l'une des revendications précédentes, **caractérisé en ce que** le système d'entraînement pour déplacer les unités en recirculation comprend une pluralité de moteurs d'entraînement (18a, 18b, 18c), et chaque unité en recirculation est en liaison active avec un propre moteur d'entraînement (18a, 18b, 18c).

10. Dispositif de manipulation selon l'une des revendications 6 à 9, **caractérisé en ce que** chaque chariot en recirculation (10) est en liaison active avec le moteur d'entraînement associé (18a, 18b, 18c) au moyen d'un arbre d'entraînement séparé (22a, 22b, 22c) et d'un bras d'entraînement (13a, 13b, 13c) qui s'étend depuis l'arbre d'entraînement (22a, 22b, 22c) vers le chariot en recirculation (10) associé.

11. Dispositif de manipulation selon la revendication 10, **caractérisé en ce que** les arbres d'entraînement (22a, 22b, 22c) des chariots en recirculation (10) individuels sont agencés les uns dans les autres et capables de rotation autour d'un axe médian commun (11).

12. Dispositif de manipulation selon la revendication 11, **caractérisé en ce que** l'un au moins des arbres d'entraînement (22a, 22b, 22c) sert de console de montage pour au moins un autre arbre d'entraînement (22a, 22b, 22c).

13. Dispositif de manipulation selon l'une des revendications 6 à 12, **caractérisé en ce qu'**il est prévu un système de transmission de puissance électrique pour la transmission d'un courant électrique entre une source de production de courant stationnaire et les chariots en recirculation (10), ledit système de transmission de puissance comprenant des bagues-frotteurs (56.1, 56.2, 56.3) qui sont agencées de façon stationnaire les unes à côté des autres le long d'un axe médian (11), et des balais-frotteurs (60a, 60b, 60c) qui coopèrent avec les bagues-frotteurs et qui sont fixés sur les bras d'entraînement (13 a, 13b, 13c).

14. Dispositif de manipulation selon la revendication 13, **caractérisé en ce que** plusieurs balais-frotteurs (60a, 60b, 60c) sont agencés de façon répartie sur la périphérie des bagues-frotteurs (56.1, 56.2, 56.3).

15. Dispositif de manipulation selon l'une des revendications 6 à 14, **caractérisé en ce qu'**il est prévu un système de transmission de données pour la transmission de données entre une installation de traitement de données stationnaire et les chariots en recirculation (10), ledit système de transmission de données comprenant une pluralité de groupes de bagues-frotteurs (62, 63, 64, 65) comprenant une pluralité de bagues-frotteurs, qui sont agencées les unes à côté des autres de façon stationnaire le long d'un axe médian (11), et des ressorts-frotteurs (67a, 67b, 67c) qui coopèrent avec les bagues-frotteurs et qui sont fixés sur les bras d'entraînement (13a, 13b, 13c).

16. Dispositif de manipulation selon la revendication 15, **caractérisé en ce que** les bagues-frotteurs du système de transmission de puissance électrique et du système de transmission de données sont agencées au voisinage étroit les unes à côté des autres.

17. Dispositif de manipulation selon l'une des revendications 9 à 17, **caractérisé en ce que** l'un des arbres d'entraînement (22a, 22b, 22c) est en liaison avec un système de transmission de vide/fluide (54) agencé en alignement avec ledit arbre, au moyen duquel un vide et/ou un fluide peut être transmis depuis une source d'alimentation de vide/fluide vers les unités de maintien (12).

18. Dispositif de manipulation selon la revendication 17, **caractérisé en ce que** le système de transmission de vide/fluide (54) comprend un boîtier (68) relié solidairement en rotation à l'arbre d'entraînement (22c) et une partie centrale (72) agencée à l'intérieur du boîtier (68) et fixée de manière stationnaire dans le dispositif de manipulation, ladite partie centrale réalisant, via des perçages axiaux (77) et des perçages radiaux (78) qui leur sont associés, une liaison de vide/fluide vers des traversées radiales (84) du boîtier (68) en rotation conjointe avec l'arbre d'entraînement (22c).
